(19) Europäisches Patentamt / European Patent Office / Office européen des brevets

(11) **EP 2 947 689 B1**

(12) **FASCICULE DE BREVET EUROPEEN**

(45) Date de publication et mention de la délivrance du brevet:
**19.08.2020 Bulletin 2020/34**

(51) Int Cl.:
*H01L 27/144* *(2006.01)*    *H01L 21/84* *(2006.01)*
*H01L 27/12* *(2006.01)*    *G02F 3/02* *(2006.01)*

(21) Numéro de dépôt: **15168852.0**

(22) Date de dépôt: **22.05.2015**

(54) **INVERSEUR CMOS PHOTONIQUE**

PHOTONISCHER CMOS-WECHSELRICHTER

PHOTONIC CMOS INVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.05.2014 FR 1454686**

(43) Date de publication de la demande:
**25.11.2015 Bulletin 2015/48**

(73) Titulaire: **Commissariat à l'Énergie Atomique et aux Énergies Alternatives 75015 Paris (FR)**

(72) Inventeurs:
- **Grenouillet, Laurent 38000 Grenable (FR)**
- **Rozeau, Olivier 38430 Moirans (FR)**

(74) Mandataire: **Brevalex 95, rue d'Amsterdam 75378 Paris Cedex 8 (FR)**

(56) Documents cités:
**EP-A1- 2 587 539       EP-A2- 1 976 012
WO-A2-03/102510       US-A- 4 954 895
US-A1- 2009 003 105   US-A1- 2009 294 822
US-A1- 2013 049 117**

- **TSUCHIYA R ET AL: "Silicon on thin BOX: a new paradigm of the CMOSFET for low-power and high-performance application featuring wide-range back-bias control", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE, 13 décembre 2004 (2004-12-13), pages 631-634, XP010788872, DOI: 10.1109/IEDM.2004.1419245 ISBN: 978-0-7803-8684-6**

EP 2 947 689 B1

## Description

## DOMAINE TECHNIQUE ET ART ANTÉRIEUR

La présente invention se rapporte au domaine des dispositifs photosensibles et concerne la mise en œuvre d'une cellule logique photosensible encore appelée inverseur logique photonique.

Dans le domaine technique des dispositifs photosensibles, le document US2009/003105A1 présente un dispositif DRAM comprenant un inverseur logique formé de transistors réalisés sur un substrat de type semi-conducteur sur isolant. Le document

EP 2°587°539 présente un dispositif microélectronique formé d'un transistor réalisé sur un substrat de type semi-conducteur sur isolant dont la tension de seuil peut être modulée en fonction d'une quantité de photons reçue par une zone photosensible située dans la couche de support semi-conductrice du substrat et séparée de la zone de canal du transistor par le biais de la couche isolante du substrat. La variation de tension de seuil du transistor est permise grâce à l'établissement d'un couplage capacitif entre la zone photosensible et la zone de canal du transistor. Ainsi, lorsqu'il n'y a pas de rayonnement lumineux à détecter, la tension de seuil du transistor est égale à une valeur $Vt_1$, tandis que lorsqu'il y a un rayonnement lumineux à détecter, la tension de seuil du transistor est égale à une valeur $Vt_2$ différente de $Vt_1$.

A l'aide d'un tel dispositif, on peut chercher à mettre en œuvre un mode de détection binaire de rayonnement lumineux.

Il se pose le problème de réaliser un nouveau dispositif photosensible susceptible de réaliser une détection de rayonnement lumineux, et de pouvoir traduire cette détection sous forme d'un signal numérique, le tout en ayant un encombrement limité.

## EXPOSÉ DE L'INVENTION

La présente invention concerne tout d'abord une cellule logique photosensible selon la revendication 1.

Le premier transistor et le deuxième transistor sont agencés selon une configuration d'inverseur logique CMOS.

Ainsi, le premier transistor peut être doté d'une grille connectée à celle du deuxième transistor, tandis que le drain du premier transistor est connecté au drain du deuxième transistor.

Selon une première possibilité de mise en œuvre de la cellule logique photosensible, le signal d'entrée faisant varier l'état de la sortie de la cellule logique est un signal lumineux.

Selon la première possibilité de mise en œuvre de la cellule logique photosensible, celle-ci peut être configurée de manière à délivrer en sortie un signal logique $V_{OUT}$ ayant un premier état logique lorsque la zone photosensible est soumise à un premier éclairement, par exemple un éclairement nul ou faible, et pour délivrer en sortie un signal logique $V_{OUT}$ ayant un deuxième état logique, lorsque la zone photosensible est soumise à un deuxième éclairement, plus important que le premier éclairement.

Selon cette première possibilité de mise en œuvre, la première jonction et la deuxième jonction peuvent être dotées chacune d'une zone inférieure dopée P surmontée d'une zone supérieure dopée N.

En variante, la première jonction et la deuxième jonction comprennent chacune une zone dopée N surmontée d'une zone supérieure dopée P.

Selon la première possibilité de mise en œuvre de la cellule, celle-ci peut comprendre également une entrée mise à un potentiel de polarisation fixe $V_{NP}$ ou $V_{PN}$ prédéterminé qui est appliqué aux grilles du premier et du deuxième transistor, le premier transistor et le deuxième transistor étant polarisés de manière à avoir des tensions grille-source respectives constantes.

On peut ainsi avantageusement réaliser une cellule logique photosensible dont l'état logique de sa sortie dépend uniquement de la quantité de photons reçus.

La première jonction peut avantageusement être polarisée indépendamment de la deuxième jonction.

On peut ainsi prévoir des moyens pour appliquer un premier potentiel de polarisation sur la première jonction et des moyens pour appliquer un deuxième potentiel de polarisation différent du premier potentiel sur la deuxième jonction. Dans ce cas, pour un même changement d'état d'éclairement entre la première jonction et la deuxième jonction, on peut avantageusement mettre en œuvre une modulation de tension de seuil du premier transistor différente de celle mise en œuvre pour le deuxième transistor.

Afin de réaliser une isolation électrique entre la première jonction et la deuxième jonction, la cellule peut comprendre en outre au moins une tranchée isolante entre le premier transistor et le deuxième transistor, la tranchée isolante traversant la couche de support.

Des moyens de polarisation peuvent être prévus et configurés pour appliquer un potentiel Vpol déterminé de polarisation à la zone inférieure de la première jonction et/ou de la deuxième jonction, la zone supérieure de la première jonction et/ou de la deuxième jonction étant alors mise à un potentiel flottant.

Selon une deuxième possibilité de mise en œuvre de la cellule logique photosensible, le signal d'entrée faisant varier l'état de sortie de la cellule logique est un signal logique de nature électrique.

Pour cette variante de mise en œuvre, la vitesse de commutation d'un état logique à un autre en sortie de la cellule dépend de l'état d'éclairement de la cellule.

Une deuxième possibilité de mise en œuvre de la cellule logique photosensible, prévoit ainsi un moyen pour appliquer un potentiel variable $V_{IN}$ en entrée de l'inverseur.

Dans ce cas, on peut ainsi avantageusement réaliser un inverseur logique photosensible dont l'état logique de sa sortie dépend du potentiel $V_{IN}$ en entrée, comme pour un inverseur logique classique, mais dont la vitesse de transition de sa sortie entre deux états logiques dépend de la quantité de photons reçus par cette dernière, et en particulier de si la zone photosensible est exposée ou non à un rayonnement lumineux.

Selon cette deuxième possibilité de mise en œuvre de la cellule logique photosensible, l'agencement des jonctions peut être tel que la première jonction comprend une zone inférieure dopée N surmontée d'une zone supérieure dopée P, la deuxième jonction comprenant une zone inférieure dopée P surmontée d'une zone supérieure dopée N. En variante, la première jonction comprend une zone inférieure dopée P surmontée d'une zone supérieure dopée N, la deuxième jonction comprenant une zone inférieure dopée N surmontée d'une zone supérieure dopée P. La première jonction et la deuxième jonction sont ainsi orientées dans des sens différents.

Selon une possibilité de mise en œuvre de la cellule logique photosensible, on peut prévoir une zone isolante autour du premier transistor et/ou du deuxième transistor. Cette zone isolante peut traverser la couche de support et être configurée de manière à isoler électriquement ladite cellule, en particulier sa zone photosensible, par rapport à une autre cellule ou un autre élément formé dans le substrat.

La cellule logique photosensible peut être intégrée à un dispositif comprenant un ou plusieurs autres transistors dont la tension de seuil ne varie pas ou varie peu en fonction de l'éclairement du dispositif. Ces autres transistors peuvent être par exemple des transistors d'un circuit de traitement de signal connecté à la cellule logique photosensible.

Selon une possibilité de mise en œuvre, ces autres transistors peuvent être formés en regard d'un plan de masse réalisé dans la couche de support semi-conductrice.

Selon une possibilité de mise en œuvre, la cellule logique photosensible peut être intégrée à un dispositif dont les composants sont répartis sur plusieurs niveaux et comprenant en outre au moins un autre transistor agencé de sorte que la cellule logique et cet autre transistor sont superposés.

Selon une possibilité de mise en œuvre de la cellule logique photosensible, les transistors peuvent être réalisés selon une technologie de type FDSOI ou UTBB-FDSOI.

La présente invention concerne également un circuit logique pour réaliser une fonction logique déterminée telle qu'une fonction NON ET ou NON OU, ce circuit comprenant une cellule logique photosensible telle que définie plus haut.

La présente invention concerne également une cellule de mémoire SRAM (pour « Static Random Access Memory ») dont la bascule est formée d'une cellule logique photosensible telle que définie plus haut.

La présente invention concerne également un circuit logique photosensible comprenant une pluralité de cellules telles que définies plus haut.

La présente invention concerne également un circuit logique photosensible réalisant une fonction logique donnée et doté d'une ou plusieurs cellules logiques photosensibles telles que définie(s) plus haut, la fonction logique, telle qu'une fonction de programmation collective ou de remise à zéro, étant modifiable en fonction de l'éclairement du dispositif.

Selon un mode de réalisation, la présente invention prévoit un dispositif comprenant :

- une ou plusieurs cellules telles que définies plus haut et munies de jonctions formées chacune d'une zone dopée N surmontée d'une zone supérieure dopée P ou d'une zone dopée P surmontée d'une zone supérieure dopée N et
- un circuit de commande de polarisation configuré pour appliquer un échelon de tension au premier transistor et au deuxième transistor et placer la cellule dans un état d'effacement ou de réinitialisation.

Un tel échelon de tension peut permettre de décharger des régions situées à l'interface entre la couche isolante du substrat et respectivement la première et la deuxième jonction.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- les figures 1A-1C illustrent un exemple de structure de cellule logique photo-sensible mise en œuvre suivant l'invention et comportant un premier transistor et un deuxième transistor de type différents disposés en regard d'une zone photosensible, cette zone comprenant une première jonction et une deuxième jonction couplées par couplage capacitif respectivement au canal du premier transistor et au canal du deuxième transistor ;

- les figures 2A-2B illustrent un premier exemple de configuration de d'inverseur logique photosensible formé à partir de la cellule de la figure 1, pour laquelle l'état logique de la sortie de l'inverseur dépend d'une quantité de photons reçue par celui-ci, tandis que les figures 2C-2D illustrent des caractéristiques électriques de fonctionnement de cet inverseur ;
- les figures 3A-3B illustrent un deuxième exemple de configuration de d'inverseur logique photosensible suivant l'invention pour laquelle l'état logique de la sortie de l'inverseur dépend également du niveau d'éclairement de celui-ci, tandis que les figures 3C-3D illustrent des caractéristiques électriques de fonctionnement de cet inverseur;
- les figures 4A-4B illustrent un troisième exemple de configuration d'inverseur logique photosensible suivant l'invention pour laquelle l'état logique de la sortie de l'inverseur dépend de celui de son entrée, et pour laquelle la vitesse de commutation d'un état logique à un autre en sortie de l'inverseur dépend du niveau d'éclairement de celui-ci, tandis que les figures 4C-4E illustrent des caractéristiques électriques de fonctionnement de cet inverseur ;
- les figures 5A-5B illustrent un quatrième exemple de configuration d'inverseur logique photosensible suivant l'invention, tandis que les figures 5C-5D illustrent des caractéristiques électriques de fonctionnement de cet inverseur ;
- les figures 6A, 6B, 6C illustrent des exemples de fonctions logiques susceptibles d'être mises en œuvre à l'aide d'un inverseur logique photosensible suivant l'invention ;
- la figure 7 illustre un exemple de transistor réalisé en technologie finFET pour la mise en œuvre d'un inverseur logique photosensible suivant l'invention ;
- la figure 8 illustre un exemple de réalisation dans lequel les transistors d'une cellule logique photosensible sont juxtaposés à un transistor dont la tension de seuil ne varie pas ou varie peu en fonction d'une quantité de photons reçue ;
- la figure 9 illustre un exemple de dispositif à composant superposés sur plusieurs niveaux doté d'une cellule logique photosensible suivant l'invention ;
- La figure 10 illustre un exemple de moyen pour permettre de décharger une accumulation d'électrons à l'interface entre la couche isolante de BOX et les jonctions PN d'une cellule du type de celle de la figure 3A;
- Les figures 11A-11B illustrent l'effet d'un échelon de tension appliqué sur la cellule logique de la figure 10 pour permettre de décharger une accumulation d'électrons à l'interface entre la couche isolante de BOX ;
- La figure 12 illustre un exemple de moyen pour permettre de décharger une accumulation de trous à l'interface entre la couche de BOX et les jonctions NP d'une cellule du type de celle de la figure 2A;
- Les figures 13 et 14 illustrent différents exemples de réalisation d'un circuit de commande de polarisation adapté pour mettre des cellules logiques photosensibles dans différents états de polarisation et en particulier pour réaliser un effacement lors duquel une décharge de porteurs accumulés à l'interface entre la couche isolante de BOX et les jonctions est mise en œuvre;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

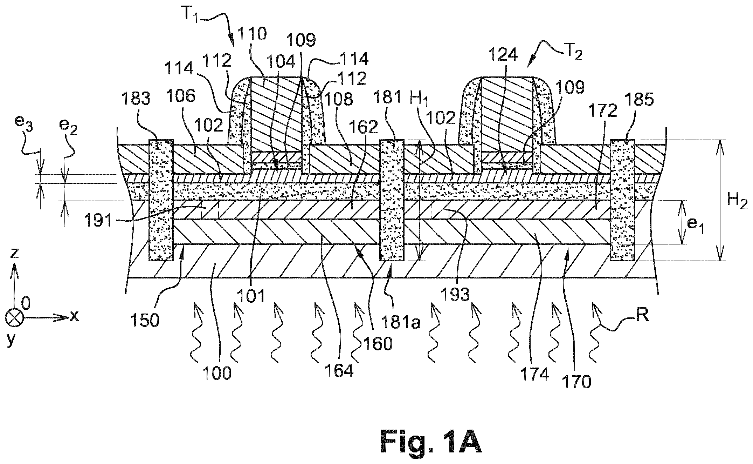

Un exemple de structure de cellule logique photosensible, mise en œuvre suivant l'invention, est donné sur la figure 1A.

Cette cellule comprend un premier transistor $T_1$ d'un premier type, par exemple de type P ainsi qu'un deuxième transistor $T_2$ d'un deuxième type, par exemple de type N, qui sont juxtaposés et formés sur un substrat de type semi-conducteur sur isolant, par exemple de type SOI (SOI pour « Silicon on Insulator » ou silicium sur isolant).

Le substrat comprend une couche de support 100 semi-conductrice, une couche isolante 101 reposant sur une face dite « face avant » de la couche de support 100, et une couche semi-conductrice 102 superficielle reposant sur la couche isolante 101 et dans laquelle le canal du premier transistor $T_1$ et du deuxième transistor $T_2$ sont prévus.

Les transistors $T_1$ et $T_2$ peuvent être des transistors MOS (MOS pour « Metal Oxide Semi-conductor ») réalisés par exemple selon une technologie de type SOI totalemAent désertée à oxyde enterré mince, appelée UTBB-FDSOI (pour « Ultra-Thin Body and Box » - « Fully Depleted Silicon On Insulator »).

La couche semi-conductrice 102 superficielle a une épaisseur $e_3$ (mesurée dans une direction parallèle à un axe z d'un repère [O; x ; y ; z]) qui peut être comprise par exemple entre 4 et 30 nm, de préférence entre 6 et 12 nm.

La couche de support 100 est configurée de manière à comporter une zone photo-sensible 150 qui s'étend en regard du premier transistor $T_1$ et du deuxième transistor $T_2$, cette zone photosensible 150 étant destinée à recevoir un rayonnement lumineux R, qui peut pénétrer par exemple en partie par une face arrière de la couche de support 100 opposée à sa face avant.

Cette zone photosensible 150 comprend une première jonction 160, par exemple une jonction de type PN en regard du premier transistor $T_1$, et une deuxième jonction 170 par exemple une jonction de type PN en regard du deuxième transistor $T_2$.

Les jonctions 160, 170, peut avoir une hauteur encore appelée épaisseur $e_1$ (mesurée parallèlement à l'axe z du repère [O; x; y; z]) comprise par exemple entre 100 nm et 5 $\mu$m.

La première jonction 160 et la deuxième jonction 170 comprennent chacune une première zone dopée 162, 172 selon un dopage d'un premier type, par exemple de type N, et une deuxième zone 164, 174 dopée selon un dopage d'un deuxième type, par exemple de type P, la première zone et la deuxième zone étant superposées.

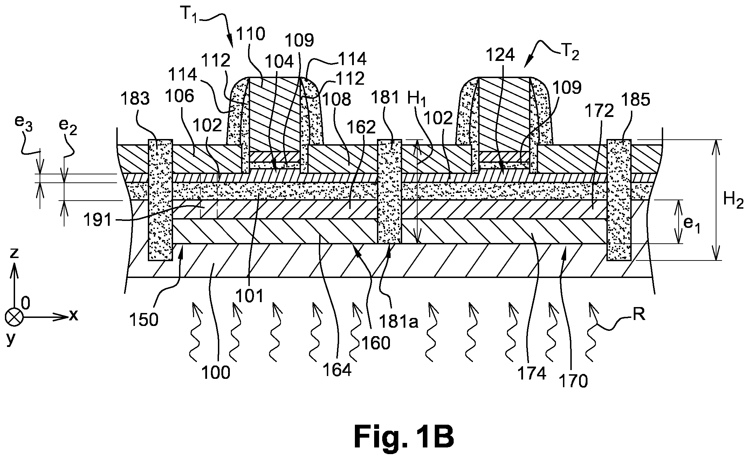

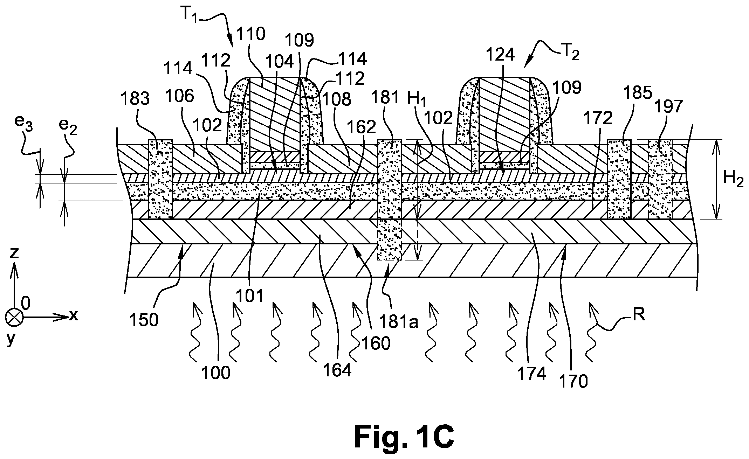

Dans l'exemple de structure de cellule logique donné sur la figure 1, l'agencement des zones dopées 162, 164 formant la première jonction 160 est tel que la première zone 162 dopée N est disposée entre la zone de canal 104 du premier transistor $T_1$ et la deuxième zone 164 dopée P. L'agencement des zones dopées 172, 174 formant la deuxième jonction 170 est quant à lui tel que la première zone 172 dopée N est disposée entre la zone de canal 124 du deuxième transistor $T_2$ et la deuxième zone 174 dopée P.

Ainsi, les deuxièmes zones 164, 174 dopées P sont dans cet exemple des zones inférieures des jonctions situées du côté de la face arrière de la couche de support 100, tandis que les premières zones 162, 172 dopées N sont des zones supérieures des jonctions situées du côté de la face avant de la couche de support 100.

La zone photosensible 150 peut être disposée dans la couche de support 100 de manière à être accolée à la couche isolante 101 de sorte que les zones dopées 162, 172 supérieures des jonctions 160, 170 sont en contact avec la couche isolante 101.

L'épaisseur $e_2$ de cette couche isolante 101 est choisie suffisamment faible pour qu'une tension photo-générée du côté de sa face arrière puisse induire une tension correspondante par couplage capacitif du côté de sa face avant.

La zone photosensible 150 et la zone de canal 104 du premier transistor $T_1$ sont ainsi séparées par l'intermédiaire de la couche isolante 101, dont la configuration, en particulier sa composition et son épaisseur $e_2$, sont prévues de manière à permettre l'établissement d'un couplage capacitif entre la première jonction 160 et la zone de canal 104 du premier transistor.

Pour permettre un tel couplage, la couche isolante 101 peut être par exemple à base de $SiO_2$ et avoir une épaisseur $e_2$ qui peut être comprise par exemple entre 5 nm et 50 nm, de préférence entre 10 et 25 nm. Le couplage capacitif est tel qu'une variation de potentiel consécutive à la réception d'un rayonnement lumineux au niveau de la zone photosensible, et en particulier de la première jonction 160 peut induire une variation $LIVS_P$ (avec « LIVS » pour « Light Induced $V_{TP}$ Shift » ou décalage de tension de seuil $V_{TP}$ induite par la lumière, ce décalage étant noté $LIVS_P$ pour un transistor de type P) de la tension de seuil $V_{TP}$ du premier transistor $T_1$. De même, la zone photosensible 150 et une zone de canal 124 du deuxième transistor $T_2$ sont séparées par l'intermédiaire de la couche isolante 101, configurée de telle sorte qu'un couplage capacitif entre la zone photosensible 150 et la zone de canal est susceptible de s'établir et de permettre d'induire une variation notée $LIVS_N$ de la tension de seuil $V_{TN}$ du deuxième transistor $T_2$ consécutivement à la réception d'un rayonnement lumineux au niveau de la zone photosensible 150, et en particulier de la deuxième jonction 160.

La variation de tension de seuil $V_{TP}$ du premier transistor $T_1$, et/ou de celle $V_{TN}$ du deuxième transistor $T_2$, consécutive à un éclairement ou une variation d'éclairement de la zone photosensible peut par exemple atteindre une valeur de l'ordre de 100 mV voire 350 mV ou même de 500 mV.

En adaptant les épaisseurs respectives $e_2$ de la couche isolante 101, et/ou $e_3$ de la couche semi-conductrice superficielle 102, et/ou du diélectrique de grille des transistors on peut ajuster le décalage de tension de seuil.

Une diminution de l'épaisseur de la couche isolante 101, et/ou une augmentation de l'épaisseur $e_3$ de la couche semi-conductrice superficielle 102, et/ou une augmentation de l'épaisseur du diélectrique de grille des transistors sont en particulier favorables à une augmentation de ce décalage de tension de seuil.

Une tranchée isolante 181, par exemple de type STI (STI pour « shallow trench isolation ») est disposée entre le premier transistor $T_1$ et le deuxième transistor $T_2$ et configurée de manière à réaliser une isolation électrique entre la première jonction 160 et la deuxième jonction 170. Cette tranchée est remplie d'un matériau diélectrique tel que par exemple du $SiO_2$. L'isolation peut être telle que lorsqu'un photon est absorbé par la zone photosensible 150 au niveau de l'une des première jonction 160 ou deuxième jonction 170, celui-ci n'impacte pas l'autre jonction, c'est-à-dire qu'il n'induit pas de création de porteur de charge dans cette autre jonction. La tranchée 181 peut avoir une hauteur $H_1$ prévue par exemple entre 50 nm et 3 $\mu$m et peut comporter une extrémité 181a disposée dans la couche de support 100 et qui dépasse par rapport à la zone dopée inférieure des jonctions 160, 170. Une polarisation de la première jonction 160 totalement indépendante de celle de la deuxième jonction 170, i.e. avec des potentiels de polarisation différents peut être ainsi éventuellement prévue.

Une ou plusieurs autres tranchées isolantes 183, 185 par exemple de type STI peuvent être également disposées autour du premier transistor $T_1$ et du deuxième transistor $T_2$. Ces autres tranchées isolantes 183, 185 qui peuvent être également remplies de matériau diélectrique tel que par exemple du $SiO_2$, sont configurées de manière à réaliser une isolation électrique entre la cellule logique et un élément extérieur également réalisé sur le substrat, par exemple une autre cellule logique photosensible ou un autre élément. La ou les tranchées 183, 185 disposées autour des transistors $T_1$, $T_2$ sont agencés de telle sorte qu'un photon absorbé au niveau de la zone photosensible 150 de la cellule logique n'impacte pas une autre zone photosensible d'une cellule logique voisine (non représentée). Les tranchées 183, 185 peuvent avoir une hauteur $H_2$ qui peut être prévue supérieure à celle $H_1$ de la tranchée isolante 181, et par exemple telle qu'elles dépassent dans la couche de support 100 sous la couche isolante 101 d'une distance par exemple de l'ordre de 200 nm.

Pour permettre de polariser la première jonction 160 et la deuxième jonction 170, un ou plusieurs éléments conducteurs 191, 193, traversant la couche semi-conductrice superficielle 102, la couche isolante 101 et une partie de la couche de support 100 peuvent être prévus. Une connexion des éléments conducteurs 191, 193 aux zones dopées inférieures 164, 174 peut être établie sans pour autant réaliser une connexion avec les zones dopées supérieures 162, 172. Pour cela, les éléments conducteurs 191, 193 peuvent être en contact avec des régions des zones dopées inférieures 164, 174 qui s'étendent dans un plan parallèle au plan principal du substrat (i.e. un plan parallèle au plan [O;x ;y] sur la figure 1) au delà des zones dopées supérieures 162, 172 et dépassent de ces zones.

Le premier transistor $T_1$ et le deuxième transistor $T_2$ comportent également des zones de source et de drain qui peuvent être formées au moins partiellement de blocs semi-conducteurs 106, 108 disposés sur la couche semi-conductrice superficielle 102.

Le premier transistor $T_1$ et le deuxième transistor $T_2$ comportent également chacun un bloc 110 de grille dont les flancs latéraux peuvent être recouverts de part et d'autre de zones isolantes formant des premiers espaceurs 112. Les premiers espaceurs 112 sont partiellement enterrés dans les zones actives respectives des transistors $T_1$, $T_2$ tandis que d'autres zones isolantes formant des deuxièmes espaceurs 114, reposent sur les zones actives respectives des transistors $T_1$, $T_2$ et sont disposées contre les premiers espaceurs 112.

Les blocs 110 de grille respectifs des transistors $T_1$, $T_2$ sont disposés sur des zones de diélectrique 109 de grille, par exemple à base de $SiO_2$ et de type oxyde de grille épais (« thick gâte oxide » ou GO2) ou d'un matériau « high-k » tel que du $HfO_2$. La zone de diélectrique 109 de grille peut avoir une épaisseur électrique en inversion Tinv comprise par exemple entre 0.7 nm et 7 nm, de préférence entre 1.5 nm et 4 nm.

Une variante de réalisation de la cellule de la figure 1A est donnée sur la figure 1B La tranchée isolante 181 disposée entre les jonctions 160, 170 de manière à réaliser une séparation entre les zones dopées 162, 172 est cette fois prévue avec une hauteur $H_1$ telle que la partie inférieure de la tranchée isolante 181 est surélevée par rapport aux zones dopées 164, 174 inférieures des jonctions 160, 170, ces zones dopées inférieures étant en contact l'une de l'autre et pouvant cette fois être mises à un même potentiel de polarisation, de préférence non flottant par exemple par l'intermédiaire d'un élément conducteur 191 auquel on applique une tension fixe. Ceci peut permettre alors de rendre plus aisé la polarisation des jonctions 160, 170.

Une autre variante de réalisation de la cellule est donnée sur la figure 1C. La ou les tranchées isolantes 183, 185 disposées autour des jonctions 160, 170 sont cette fois prévues avec une hauteur $H_2$ telle que la partie inférieure 183a, 185a des tranchées 183, 185 est surélevée par rapport aux zones dopées 164, 174 inférieures des jonctions 160, 170, ces zones dopées inférieures étant en contact l'une de l'autre et pouvant cette fois être polarisées, par l'intermédiaire d'un ou plusieurs éléments conducteurs 197 disposés à l'extérieur de la cellule logique photosensible, autour de cette dernière. Ceci peut également permettre de rendre plus aisé la polarisation des jonctions 160, 170.

En variante de l'exemple de structure qui vient d'être décrit, on peut prévoir de réaliser les transistors $T_1$, $T_2$ sur un substrat de type SGOI (pour « SiGe-on-insulator »), c'est à dire dont la couche semi-conductrice superficielle 102 est à base de SiGe, ou bien sur un substrat de type semi-conducteur sur isolant dont la couche superficielle 102 est à base d'un matériau semi-conducteur III-V.

Selon une possibilité de mise en œuvre de la structure de cellule décrite précédemment, on peut former les jonctions 160, 170 dans la couche de support du substrat 100 de type semi-conducteur par implantation ionique à travers l'empilement formé de la couche semi-conductrice superficielle 102 et de la couche isolante 101 de BOX.

Pour former les zone semi-conductrices 162, 172 de type N, on peut par exemple réaliser une implantation :

- à l'aide d'Arsenic selon une énergie comprise par exemple entre 70keV et 400 keV et une dose comprise par exemple entre $5^e12$ $cm^{-2}$ et $5^e13$ $cm^{-2}$ ou bien,
- à l'aide de Phosphore selon une énergie comprise par exemple entre 50 keV et 400 keV, et une dose comprise par exemple entre $5^e12$ $cm^{-2}$ et $5^e13cm^{-2}$.

Pour former les zones semi-conductrices 164, 174 de type P, on peut par exemple réaliser une implantation :

- à l'aide de Bore selon une énergie comprise par exemple entre 10 keV et 200 keV, et une dose comprise par exemple entre $5^e12cm^{-2}$ et $5^e13cm^{-2}$ ou bien,
- à l'aide d'Indium selon une énergie comprise par exemple entre 100keV et 300 keV, et une dose comprise par

exemple entre $5^e12cm^{-2}$ et $5^e13cm^{-2}$.

Les étapes d'implantation sont de préférence suivies d'au moins une étape de recuit pour réparer les défauts créés par l'implantation. Le recuit peut être réalisé par exemple entre 550°C et 1200°C, avec une durée choisie dans une gamme entre une ms et une dizaine de minutes.

Selon un exemple particulier, le recuit d'implantation peut être réalisé à 1050°C pendant 5s.

Une variante de réalisation des jonctions 160, 170 comprend une étape de report de celles-ci en face arrière de la couche isolante 102 de BOX, par exemple par collage.

On peut également réaliser ces jonctions par épitaxie d'un matériau semi-conducteur tel que par exemple du Si, ou du SiGe, ou du Ge, ou de l'InGaAs, ou de l'InP, ou du GaN, ou de l'InGaN sur la couche de support 100 en réalisant par exemple un dopage *in-situ* ou bien un dopage par diffusion d'espèce.

La cellule logique photosensible des figures 1A-1C peut être configurée de manière à former un inverseur logique photosensible, en particulier de type CMOS.

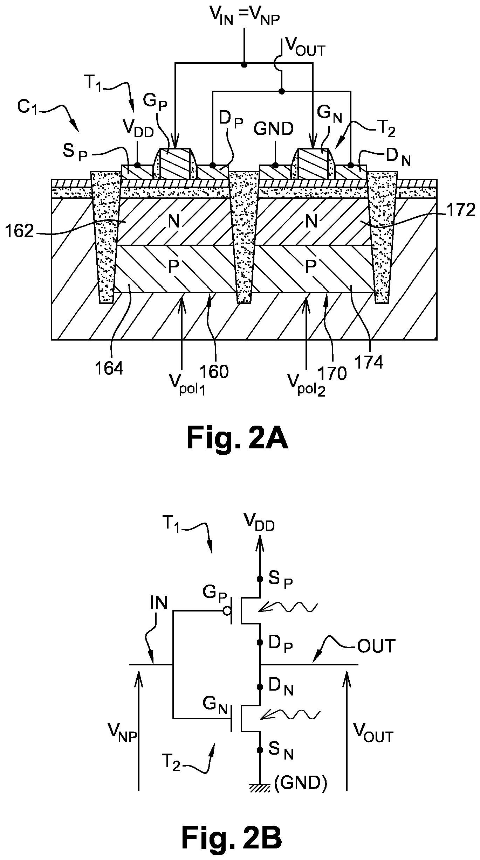

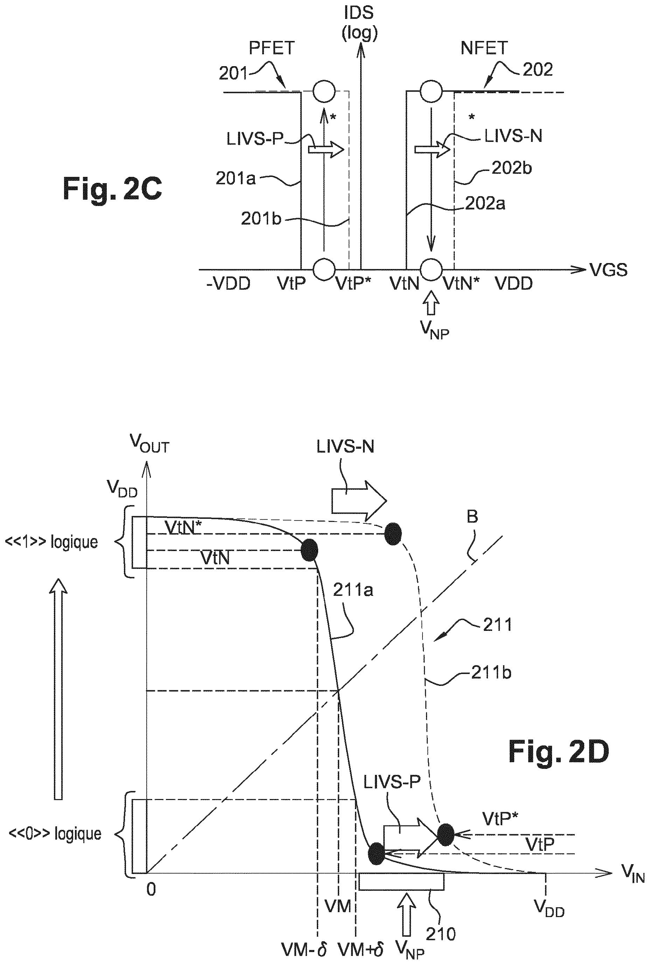

Un premier exemple de configuration d'inverseur logique photosensible CMOS formé à partir de la cellule de la figure 1, est donné sur les figures 2A-2B, tandis que les figures 2C-2D servent à illustrer le fonctionnement de cet inverseur.

Dans ce premier exemple de configuration (figures 2A et 2B), l'état logique d'un signal $V_{OUT}$ émis en sortie de l'inverseur dépend de la quantité de photons reçue par la zone photosensible en regard du premier transistor $T_1$ et du deuxième transistor $T_2$.

L'inverseur logique comporte une borne IN reliée aux grilles $G_P$ et $G_N$ respectives du premier transistor $T_1$ et du deuxième transistor $T_2$, les grilles $G_P$ et $G_N$ étant connectées entre elles.

Un moyen de polarisation est prévu pour appliquer à une borne IN de l'inverseur un potentiel de polarisation $V_{IN} = V_{NP}$ adapté, qui, dans cet exemple de configuration, est un potentiel fixe, choisi dans une gamme de tension prédéterminée.

Une sortie OUT de l'inverseur, permettant de délivrer le signal logique ou binaire $V_{OUT}$, est reliée aux drains $D_P$ et $D_N$ respectifs du premier transistor $T_1$ et du deuxième transistor $T_2$, les drains $D_P$ et $D_N$ étant connectés entre eux (figure 2B).

Le dispositif comprend également un moyen de polarisation de la source du premier transistor $T_1$ prévu pour appliquer un potentiel $V_{DD}$ à la source $S_P$ par exemple de l'ordre de 1V pour des transistors ayant une longueur de grille comprise entre 30 et 35 nm, ou de 0.9V pour des transistors ayant une longueur de grille entre 26 nm et 32 nm, ou de 0.75V pour des transistors ayant une longueur de grille entre 18 nm et 24 nm.

La source $S_N$ du deuxième transistor $T_2$ peut être placée à un potentiel $V_{SS}$ de référence ou GND servant de masse.

Ainsi, les transistors $T_1$ et $T_2$ sont dans cet exemple polarisés de manière à avoir une tension grille-source $V_{GS}$ constante, le changement d'état de conduction passant ou bloqué des transistors étant obtenu par décalage de leurs tensions de seuils $V_{TN}$, $V_{TP}$ respectives du fait d'une variation d'éclairement de la zone photosensible.

Des moyens de polarisation respectivement de la première jonction 160 et de la deuxième jonction 170 sont également prévus. Ces moyens de polarisation sont configurés pour appliquer un premier potentiel Vpol1, par exemple de l'ordre de -5V à 5V à la zone dopée inférieure 162 (dans cet exemple dopée N) de la première jonction 160 et pour appliquer un potentiel deuxième Vpol2, par exemple de l'ordre de -5V à 5V à la zone dopée inférieure 172 (dans cet exemple dopée N) de la deuxième jonction 170 tandis que les zones dopées supérieures respectives des jonctions 160, 170 (dans cet exemple les zones 164, 174 dopées P) sont mises à un potentiel flottant.

L'amplitude du décalage de tension de seuil induit par la lumière LIVS (noté $LIVS_N$ pour le transistor de type N et $LIVS_P$ pour le transistor de type P) dépend pour chaque transistor d'un rapport que l'on appelle « Body Factor » de capacité entre son canal et une région de la zone photosensible jouant le rôle d'une grille arrière, Le Body Factor (BF) dépend du potentiel de polarisation appliqué (respectivement Vpol1 pour le premier transistor et Vpol2 pour le deuxième transistor) aux zones dopées inférieures 172, 174.

On peut prévoir par exemple d'appliquer un même potentiel de polarisation Vpol1=Vpol2 à la zone dopée inférieure 162 et à la zone dopée inférieure 172.

En variante des potentiels de polarisation $Vpol_1$ et $Vpol_2$ différents peuvent être appliqués respectivement à la zone dopée inférieure 162 et à la zone dopée inférieure 172, de manière à mettre en œuvre un décalage de tension de seuil induite par la lumière $LIVS_P$ pour le premier transistor de type P différent du décalage de tension de seuil induite par la lumière $LIVS_N$ pour le deuxième transistor de type N.

Le signe de la tension Vpol1, Vpol2 appliquée pour contrôler le décalage de tension de seuil LIVS dépend du sens de la jonction (P/N ou N/P), sous la couche isolante de BOX sur laquelle les canaux des transistors repose.

Sur la figure 2C, des courbes 201, 202 de variations respectives des courants drain-source du premier transistor $T_1$ et du deuxième transistor $T_2$ en fonction de leurs tensions grille-source respectives sont données. Cette figure montre des décalages de tensions de seuil $LIVS_P$ du premier transistor $T_1$ et $LIVS_N$ du deuxième transistor $T_2$ engendrés par

la réception d'une quantité de photons donnée ou par une augmentation donnée d'une quantité de photons reçus par la zone photosensible disposée en regard des transistors $T_1$, $T_2$.

La tension de seuil du premier transistor $T_1$ est susceptible de passer d'une valeur Vtp lorsque la zone photosensible n'est pas éclairée ou insuffisamment éclairée (portion 201a de la courbe 201 en trait continu) à une valeur Vtp* lorsque la zone photosensible est éclairée ou suffisamment éclairée (portion 201b de la courbe 201 en trait discontinu), avec |Vtp * -Vtp| qui peut être par exemple de l'ordre de 100 mV. A quantité de photons reçue par la zone photosensible égale, cette différence de tension de seuil |Vtp * -Vtp| peut être augmentée en diminuant l'épaisseur $e_2$ de la couche isolante 101 du substrat plus faible, et/ou en augmentant l'épaisseur $e_3$ choisie de la couche semi-conductrice superficielle, et/ou en augmentant l'épaisseur choisie du diélectrique de grille du premier transistor $T_1$.

De même, la tension de seuil du deuxième transistor $T_2$ est susceptible de passer d'une valeur Vtn lorsque la zone photosensible n'est pas éclairée ou insuffisamment éclairée (portion 202a de la courbe 202 en trait continu) à une valeur Vtn* lorsque la zone photosensible est éclairée ou suffisamment éclairée (portion 202b de la courbe 202 en trait discontinu), avec Vtn*-Vtn qui peut être par exemple de l'ordre de 100 mV.

Dans cet exemple de configuration, l'agencement des zones dopées P et N des jonctions 160, 170 est tel, qu'un changement d'éclairement de la zone photosensible provoque un décalage des tensions de seuil respectives Vtn et Vtp des transistors dans un même sens de variation (VtN augmentant et VtP diminuant en valeur absolue). Ainsi, une augmentation de la quantité de photons reçue par la zone photosensible de l'inverseur logique est ici susceptible d'induire une diminution (en valeur absolue) de la tension de seuil du premier transistor $T_1$ (de type P) et une augmentation de la tension de seuil du deuxième transistor $T_2$ (de type N).

La figure 2D illustre une fonction de transfert du signal de sortie $V_{OUT}$ en fonction du signal appliqué en entrée du premier exemple d'inverseur logique lorsque celui-ci est soumis à un rayonnement lumineux (portion de courbe 211a) et lorsque celui-ci n'est pas soumis à un rayonnement lumineux (portion de courbe 211b).

Lorsque le potentiel $V_{NP}$ fixe de polarisation appliqué sur la borne IN est choisi dans une gamme de tension adaptée (indiquée par une portion 210 sur l'axe des abscisses) et lorsque la zone photosensible de l'inverseur passe d'un premier état d'éclairement (par exemple un état non-éclairé ou d'éclairement insuffisant) à un deuxième état d'éclairement plus important, le signal $V_{OUT}$ en sortie de l'inverseur est susceptible de passer d'un niveau $V_{OUT}$= 0V représentatif par exemple d'un 0 logique en sortie de l'inverseur à un niveau $V_{OUT}$= $V_{DD}$ représentatif par exemple d'un 1 logique en sortie de l'inverseur.

Le fonctionnement est réversible de sorte que lorsque le potentiel $V_{NP}$ fixe de polarisation de la borne IN est situé dans la gamme de tension adaptée, le signal $V_{OUT}$ en sortie de l'inverseur est susceptible de passer d'un niveau $V_{OUT}$=$V_{DD}$ représentatif par exemple d'un 1 logique à un niveau $V_{OUT}$=0V représentatif par exemple d'un 0 logique consécutivement à un passage de la zone photosensible de l'inverseur du deuxième état d'éclairement (éclairé ou d'éclairement suffisant) au premier état d'éclairement (non-éclairé ou d'éclairement insuffisant).

Le potentiel de polarisation $V_{NP}$ est dans cet exemple choisi de manière à être supérieur à un potentiel $V_M$ correspondant au potentiel pour lequel le potentiel $V_{OUT}$ en sortie OUT de l'inverseur est égal au potentiel $V_{IN}$ appliqué à la borne IN. Le potentiel $V_M$ est défini comme le point dans la courbe de transfert de l'inverseur pour lequel $V_{IN}$=$V_{OUT}$ (et qui correspond à une intersection entre la courbe de transfert 211 avec une bissectrice B d'un angle formé par les axes d'un repère sur lequel la courbe 211 est représentée).

Le potentiel de polarisation $V_{NP}$ est choisi de préférence tel que $V_{NP}$ est supérieur à $V_M + \delta$ avec $\delta$ une tension dépendante de la marge au bruit et qui est fonction de la tension $V_{DD}$.

On choisit avantageusement le potentiel de polarisation $V_{IN}$=$V_{NP}$ appliqué à la borne IN tel que :

$$V_M + \delta < V_{NP} < V_M + \delta + \frac{LIVS_N + |LIVS_P|}{2}$$

Or,

$$V_M = \frac{V_{DD} - |Vt_P| + Vt_N \sqrt{\frac{\beta_N}{\beta_P}}}{1 + \sqrt{\frac{\beta_N}{\beta_P}}}$$

avec :

$$\beta_N = \mu_N * Cox_N * \left(\frac{W}{L}\right)_N$$

$$\beta_P = \mu_P * Cox_P * \left(\frac{W}{L}\right)_P$$

Alors qu'un inverseur classique bascule à une tension $V_M$, on peut considérer dans le cas présent que :

- le niveau de sortie logique est à un niveau logique 1 lorsque $V_{IN} < V_M - \delta$,
- le niveau de sortie logique est à un niveau logique 0 lorsque $V_{IN} > V_M + \delta$,

Nous définissions :

$$|Vt_P^*| = |Vt_P| + LIVS_P$$

avec :

$LIVS_P < 0$ pour un agencement BOX/N/P des zones dopées N et P des jonctions c'est à dire telle que sur la figure 2A et

$$Vt_N^* = Vt_N + LIVS_N$$

avec :

$LIVS_N > 0$ pour un agencement BOX/N/P des zones dopées N et P de la deuxième jonction tel que sur la figure 2A.

Le potentiel $V_{NP}$ de polarisation de l'entrée IN peut être choisi par exemple de sorte que $V_{NP} \in$ [VM ; VM + 200 mV] $V_M$ dépendant de $Vt_N$, Vtp, et de $V_{DD}$.

Si on applique à l'inverseur logique photosensible un premier niveau d'éclairement, le transistor $T_2$ de type N est passant et le transistor $T_1$ de type P est bloqué. On place ainsi la sortie au potentiel Vss ou de masse, c'est-à-dire à l'état bas. Inversement, quand on applique à l'inverseur logique photosensible un deuxième niveau d'éclairement, le transistor $T_1$ de type P est passant et le transistor $T_2$ de type N est bloqué. La sortie se trouve donc au potentiel $V_{DD}$ qui traduit un état haut. On a donc réalisé une fonction inversion ou un NON logique.

Le premier exemple d'inverseur logique photonique peut ainsi suivre la table de vérité suivante :

| IN | Lumière | OUT |
|----|---------|-----|
| $V_{NP}$ | NON | 0 |
| $V_{NP}$ | OUI | 1 |

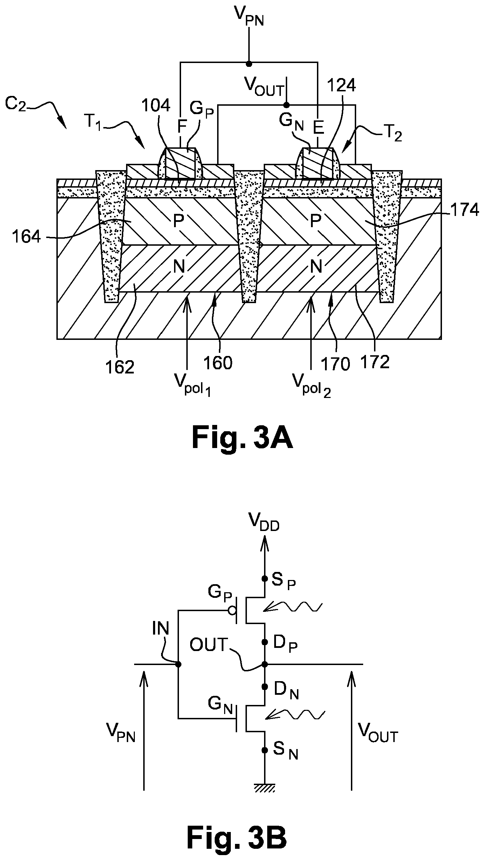

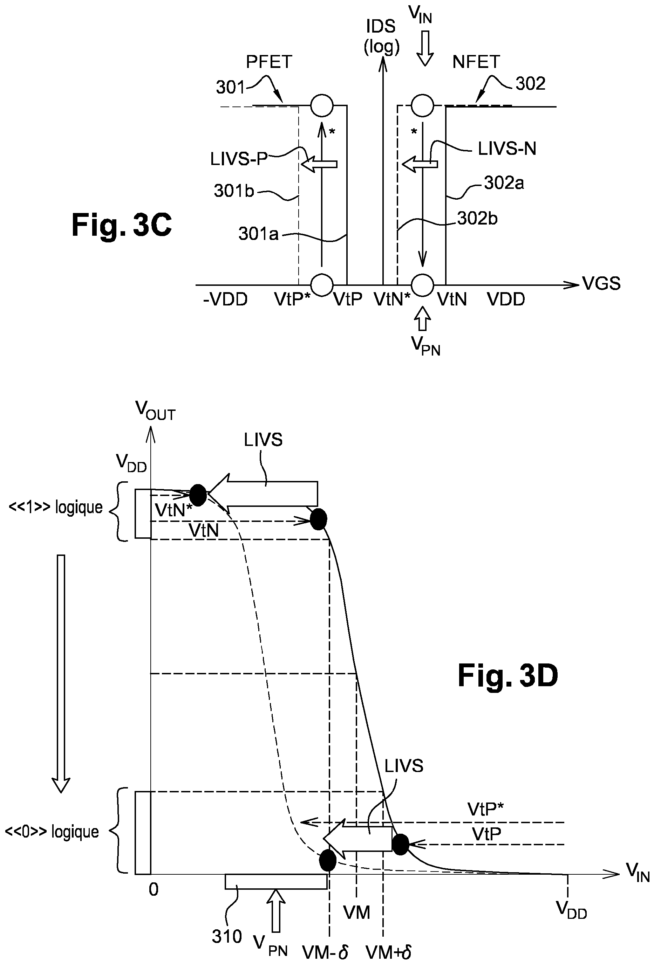

Un deuxième exemple de configuration d'inverseur logique photosensible est donné sur les figures 3A-3B, tandis que les figures 3C-3D servent à illustrer son fonctionnement.

La configuration du deuxième exemple d'inverseur diffère de celle de l'inverseur décrit précédemment notamment de par l'agencement des jonctions 160, 170.

L'agencement des zones dopées 162, 164 formant la première jonction 160 est dans cet exemple (figure 3A) tel que la zone 164 dopée P est disposée entre la zone de canal 104 du premier transistor $T_1$ et la zone 162 dopée N. L'agencement des zones dopées 172, 174 formant la deuxième jonction 170 est quant à lui tel que la zone 174 dopée P est disposée entre la zone de canal 124 du deuxième transistor $T_2$ et la deuxième zone 172 dopée N.

Ainsi, les deuxièmes zones 164, 174 dopées P forment dans cet exemple les zones supérieures des jonctions, tandis que les zones 162, 172 dopées N forment les zones inférieures des jonctions.

Des moyens de polarisation respectivement de la première jonction 160 et de la deuxième jonction 170 peuvent être prévus pour appliquer un premier potentiel Vpol$_1$ à la zone dopée inférieure 162 (dans cet exemple dopée N) de la première jonction 160 et un deuxième potentiel Vpol$_2$ à la zone dopée inférieure 172 (dans cet exemple dopée N) de la deuxième jonction 170, tandis que les zones dopées supérieures respectives des jonctions 160, 170 dans cet exemple les zones 164, 174 dopées P des jonctions sont mises à un potentiel flottant.

En ce qui concerne l'agencement des transistors (figure 3B) et la polarisation de leurs électrodes de source

$S_P$ et $S_N$ respectives, la configuration du deuxième exemple d'inverseur est semblable à celle du premier exemple d'inverseur décrit précédemment.

La borne IN reliée aux grilles $G_P$ et $G_N$ respectives du premier transistor $T_1$ et du deuxième transistor $T_2$, est cette fois mise à un potentiel de polarisation $V_{PN}$ fixe adapté. Les transistors $T_1$ et $T_2$ sont ainsi polarisés de manière à avoir une tension grille-source $V_{GS}$ constante, un changement d'état passant ou bloqué respectif des transistors pouvant être obtenu en faisant varier leurs tensions de seuil $V_{TP}$ et $V_{TN}$ respectives, cette variation étant elle-même dépendante de l'état d'éclairement de la zone photosensible.

La figure 3C donne des courbes de variations 301, 302 des courants drain-source respectifs du premier transistor $T_1$ et du deuxième transistor $T_2$ en fonction de leurs tensions grille-source respectives. Elle montre des décalages $LIVS_P$ et $LIVS_N$ (illustrés respectivement par un décalage entre la portion de courbe 301a et la portion de courbe 301b pour le transistor de type P et par un décalage entre la portion de courbe 302a et la portion de courbe 302b pour le transistor de type N) des tensions de seuil respectives du premier transistor et du deuxième transistor engendrées par un éclairement ou une augmentation d'éclairement de la zone photosensible.

La tension de seuil du premier transistor $T_1$ (de type P) augmente en valeur absolue, tandis que la tension de seuil du deuxième transistor $T_2$ (de type N) diminue en valeur absolue. Le décalage de tension de seuil Vt se fait ici dans le même sens (négatif).

Dans cet exemple, pour que la sortie de l'inverseur puisse basculer d'un état logique à un autre en fonction de l'état d'éclairement de la zone photosensible, on polarise l'entrée IN de l'inverseur à un potentiel $V_{PN}$ fixe choisi dans une gamme (portion 310 sur l'axe des abscisses de la figure 3D) de tensions adaptée.

Le potentiel de polarisation $V_{PN}$ est dans cet exemple choisi de manière à être inférieur au potentiel $V_M$ et de préférence tel que $V_{PN}$ est inférieur à $V_M - \delta$ avec $\delta$ une tension dépendante de la marge au bruit.

On choisit avantageusement le potentiel de polarisation $V_{PN}$ appliqué à la borne IN tel que :
Pour un agencement BOX/P/N des zones dopées des jonctions tel qu'illustré sur la figure 3A, on définit $V_{PN}$ par :

$$V_M - \delta - \frac{LIVS_P + |LIVS_N|}{2} < V_{PN} < V_M - \delta$$

avec $LIVS_P > 0$ et $LIVS_N < 0$.

Lorsque le potentiel $V_{PN}$ de polarisation de l'entrée IN est choisi dans la gamme de tension adaptée et lorsque la zone photosensible de l'inverseur est dans un premier état non-éclairé ou d'éclairement insuffisant le signal $V_{OUT}$ en sortie de l'inverseur est à un niveau $V_{OUT} = V_{DD}$ représentatif par exemple d'un '1' logique en sortie de l'inverseur. Lorsque le potentiel $V_{PN}$ de polarisation de l'entrée IN est choisi dans la gamme de tension adaptée et lorsque la zone photosensible de l'inverseur est dans un deuxième état éclairé ou d'éclairement suffisant, le signal $V_{OUT}$ en sortie de l'inverseur est à un niveau $V_{OUT} = 0V$ représentatif par exemple d'un '0' logique en sortie de l'inverseur.

Le deuxième exemple d'inverseur logique photonique peut ainsi suivre la table de vérité suivante :

| IN | Lumière | OUT |
|---|---|---|
| $V_{NP}$ | NON | 1 |
| $V_{NP}$ | OUI | 0 |

A l'aide de cellules photosensibles telles que décrites précédemment, on peut mettre en œuvre un circuit logique apte à être commandé par la lumière et dont les fonctions, en particulier logiques, sont modifiables en fonction du niveau d'éclairement que ce circuit logique reçoit. Les figures 2D et 3D montrent que, dans une certaine gamme de tension appliquée à l'entrée IN d'un inverseur logique photosensible on peut faire basculer, par une variation d'éclairement et un apport suffisant de photons, la sortie logique OUT de l'inverseur, l'état logique de cette sortie OUT ne basculant pas lorsque l'apport de photons est insuffisant. La fonction modifiable par éclairement peut être par exemple une fonction de programmation collective de cellules ou de remise à zéro. Un tel circuit logique peut être mis en œuvre par exemple de sorte qu'une brève impulsion lumineuse ou un flash lumineux permette de faire basculer un ensemble d'inverseurs logiques photosensibles. Un circuit logique commandé, ou programmé, ou remis à zéro, sans nécessiter d'adressage spécifique, par l'intermédiaire d'un flash lumineux appliqué par exemple en face arrière d'une puce sur laquelle ce circuit est monté peut être ainsi réalisé.

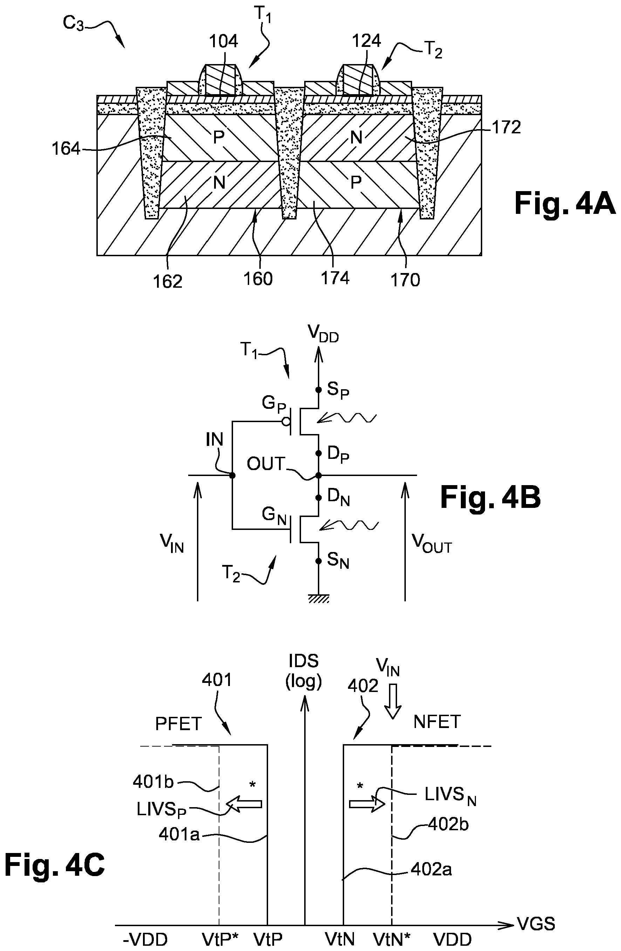

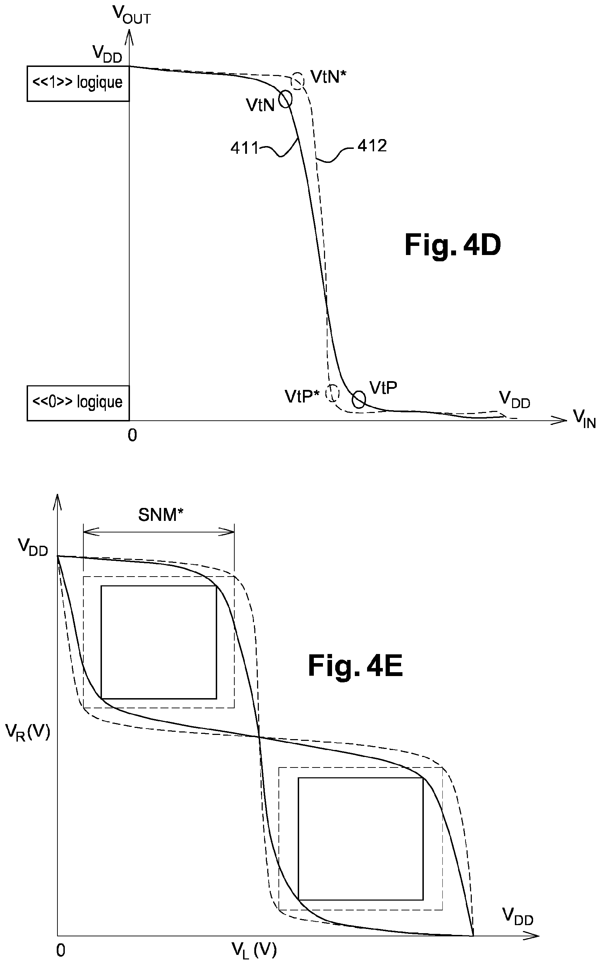

Une variante de configuration d'inverseur logique photosensible est donnée sur les figures 4A-4B, les figures 4C-4E servant à illustrer son fonctionnement.

Pour cette variante, l'état logique '1' ou '0' du signal de sortie $V_{OUT}$ de l'inverseur ne dépend ici pas, contrairement aux exemples précédemment décrits, de la quantité de photons reçue par la zone photosensible autrement dit de l'état d'éclairement de cette dernière, mais d'un état logique '0' ou '1' d'un signal électrique d'entrée $V_{IN}$ appliqué en entrée IN de l'inverseur.

Ainsi, cette variante de configuration d'inverseur logique photosensible diffère des exemples décrits précédemment de par le type de signal $V_{IN}$ appliqué en entrée IN (figure 4B), ce signal étant une tension variable, susceptible d'adopter au moins une première valeur pour laquelle le transistor $T_1$ de type P est bloqué tandis que le transistor $T_2$ de type N est passant, et au moins une deuxième valeur pour laquelle le transistor $T_1$ de type P est passant tandis que le transistor $T_2$ de type N est bloqué.

Ce troisième exemple d'inverseur diffère également de ceux décrits précédemment de par l'agencement des jonctions 160, 170.

L'agencement des zones dopées 162, 164 formant la première jonction 160 est tel que la zone 164 dopée P est disposée sur la zone 162 dopée N, tandis que celui de la deuxième jonction 170 est tel que la zone 172 dopée N est disposée sur la zone 174 dopée P (figure 4A).

Sur la figure 4C, des courbes 401, 402 de variations respectives des courants drain-source du premier transistor $T_1$ et du deuxième transistor $T_2$ en fonction de leurs tensions grille-source respectives sont données.

Cette figure montre qu'une augmentation de la quantité de photons reçus par la zone photosensible est susceptible de générer une augmentation de la tension de seuil du deuxième transistor $T_2$ cette augmentation étant traduite par un décalage entre une portion de courbe 402a en trait continu illustrant un état non-éclairé de la zone photosensible et une portion de courbe 402b en trait discontinu illustrant un état éclairé de la zone photosensible. De même, une augmentation de la quantité de photons reçus par la zone photosensible est susceptible de générer une augmentation (en valeur absolue) de la tension de seuil du premier transistor $T_1$.

Pour cette variante de configuration, l'inverseur logique photosensible a une fonction de transfert d'un inverseur classique lorsqu'il ne reçoit pas de rayonnement lumineux. La rapidité de transition en sortie OUT d'un état logique vers un autre état logique se traduit alors par une pente donnée de la portion de courbe 411 sur la figure 4D. Lorsque l'inverseur logique photosensible reçoit un rayonnement lumineux la rapidité de transition d'un état logique vers un autre état logique est dans ce cas plus importante ce qui se traduit par une pente de la portion de courbe 412 sur la figure 4D plus élevée que celle de la portion de courbe 411.

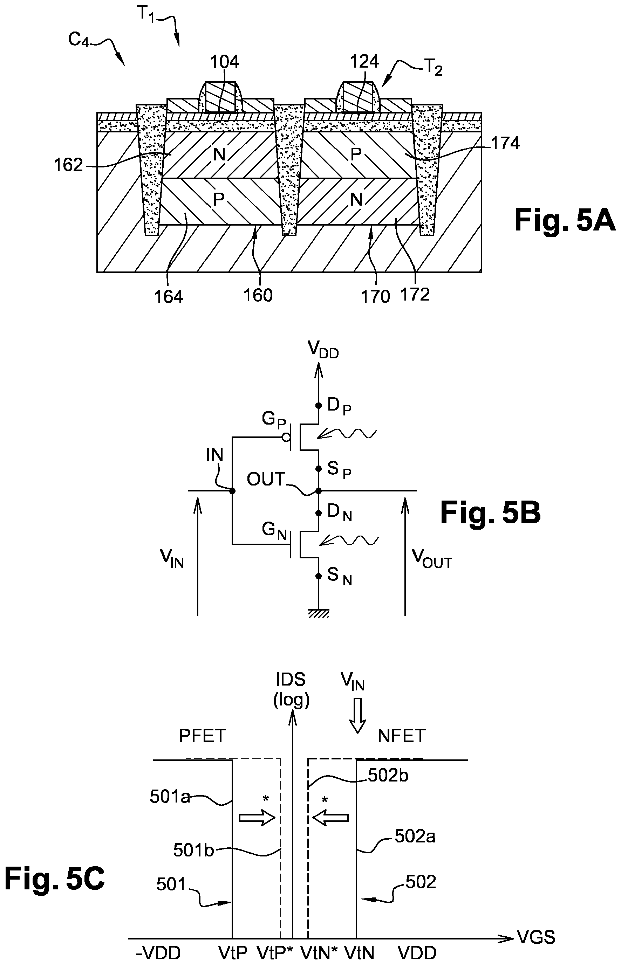

Les figures 5A-5D servent à illustrer un autre exemple de configuration d'inverseur logique photosensible qui diffère de l'exemple précédemment décrit notamment de par l'agencement des jonctions 160, 170 (figure 5A).

Dans ce quatrième exemple, l'agencement des zones dopées 162, 164 formant la première jonction 160 est tel que la zone 162 dopée N est disposée entre la zone de canal 104 du premier transistor $T_1$ et la zone 164 dopée P. L'agencement des zones dopées 172, 174 formant la deuxième jonction 170 est quant à lui tel que la zone 174 dopée P est disposée entre la zone de canal 124 du deuxième transistor $T_2$ et la zone 172 dopée N.

La figure 5C, donne des courbes 501, 502 de variations respectives des courants drain-source du premier transistor $T_1$ et du deuxième transistor $T_2$ en fonction de leurs tensions grille-source et montre qu'une augmentation de la quantité de photons reçus par la zone photosensible est susceptible de générer une diminution (en valeur absolue) de la tension de seuil du premier transistor $T_1$ (diminution traduite par un décalage entre une portion de courbe 501a en trait continu illustrant un état non-éclairé de la zone photosensible et une portion de courbe 501b en trait discontinu illustrant un état éclairé de la zone photosensible) tandis qu'une diminution de la tension de seuil du deuxième transistor $T_2$ (diminution traduite par un décalage entre une portion de courbe 501a en trait continu illustrant un état non-éclairé de la zone photosensible et une portion de courbe 502b en trait discontinu illustrant un état éclairé de la zone photosensible).

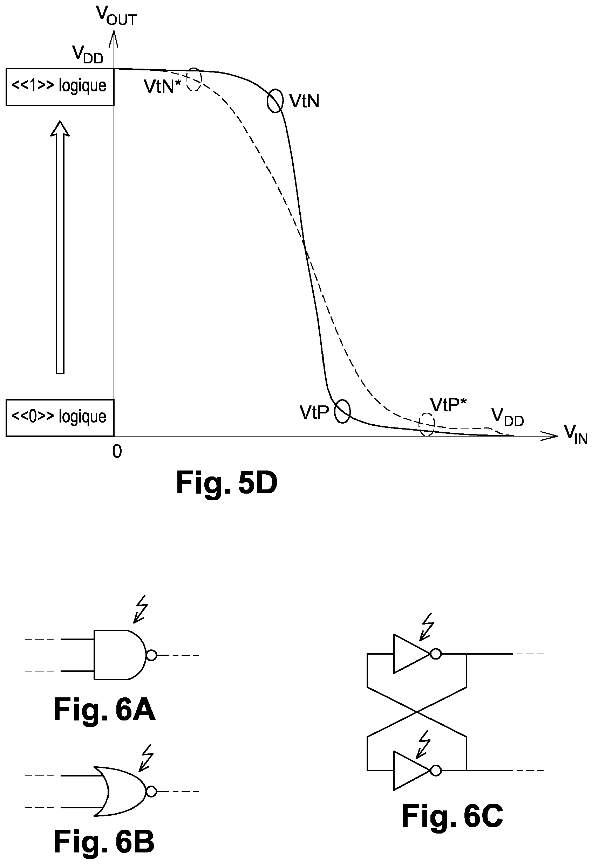

Pour cet exemple de réalisation, comme pour le précédent, la vitesse de commutation d'un état logique vers un autre état logique en sortie OUT dépend de l'état d'éclairement de la zone photosensible (figure 5D).

Un agencement matriciel d'inverseur logique photosensible suivant l'un ou l'autre des modes de réalisation décrits précédemment peut être prévu.

A l'aide d'un inverseur logique photosensible selon l'une ou l'autre des configurations décrites précédemment, on peut également mettre en œuvre un circuit logique comprenant au moins une porte logique requérant une fonction logique inverseuse ou « NON », par exemple une porte logique « NON ET » (figure 6A) photosensible ou « NON OU » photosensible (figure 6B).

Un inverseur logique photosensible peut être également intégré dans un circuit formant une bascule photosensible (figure 6C), par exemple une bascule de mémoire SRAM.

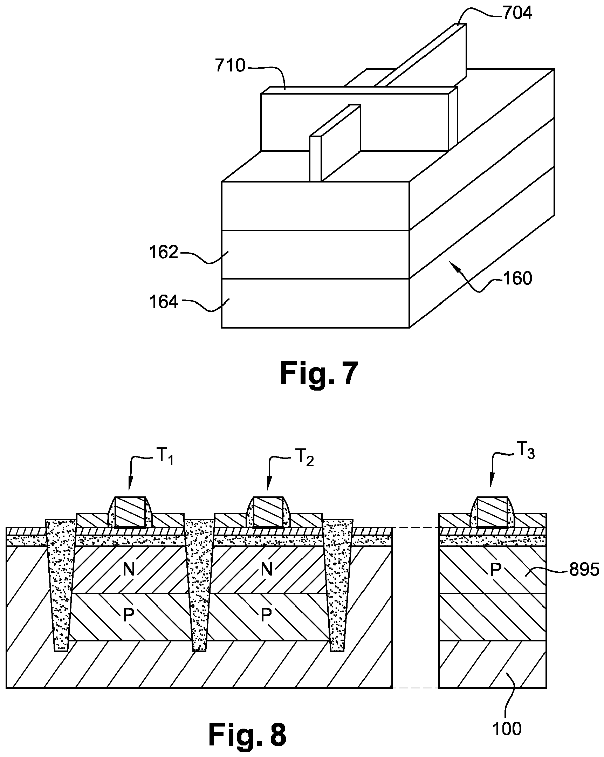

Selon une variante de réalisation de l'un ou l'autre des exemples de dispositifs qui viennent d'être décrits, on peut prévoir de former le transistor $T_1$ de type P et le transistor $T_2$ de type N de l'inverseur selon une technologie de type finFET, c'est-à-dire avec une zone de canal sous forme d'un barreau semi-conducteur 704 gravé qui s'étend sur la couche isolante 101 du substrat, et une grille 710 enrobant une portion du barreau semi-conducteur 704. La figure 8 illustre un exemple de réalisation du premier transistor $T_1$ de type P de la cellule logique photosensible selon une telle technologie finFET. La jonction 160 formée de la zone dopée N 162 et de la zone dopée P 164 superposées s'étend dans la couche de support en regard d'une portion du barreau semi-conducteur 704 recouverte par la grille 710 et destinée à former un canal.

Un inverseur logique photosensible tel que décrit précédemment peut être intégré au sein d'un dispositif comportant un ou plusieurs autres transistors, par exemple des transistors d'un circuit de traitement, dont la tension de seuil ne varie pas ou varie peu en fonction d'un rayonnement lumineux reçu par une zone de la couche de support située en regard de ce dernier.

Sur la figure 8, un exemple d'un tel dispositif est illustré et comporte un transistor $T_3$ juxtaposé aux transistors $T_1$ et $T_2$ formant une cellule logique photosensible en regard duquel une zone dopée 895 unique est prévue dans une région de la couche de support 100. Cette zone dopée 895, par exemple de type P et à laquelle un potentiel de polarisation peut être appliqué, forme un plan de masse (« ground plane » selon la terminologie anglo-saxonne) en remplacement de la zone photosensible, afin de rendre le transistor $T_3$ insensible à un rayonnement lumineux.

Selon une autre possibilité de mise en œuvre, un inverseur logique photosensible suivant l'invention peut être intégré à un dispositif comportant plusieurs niveaux de transistors superposés.

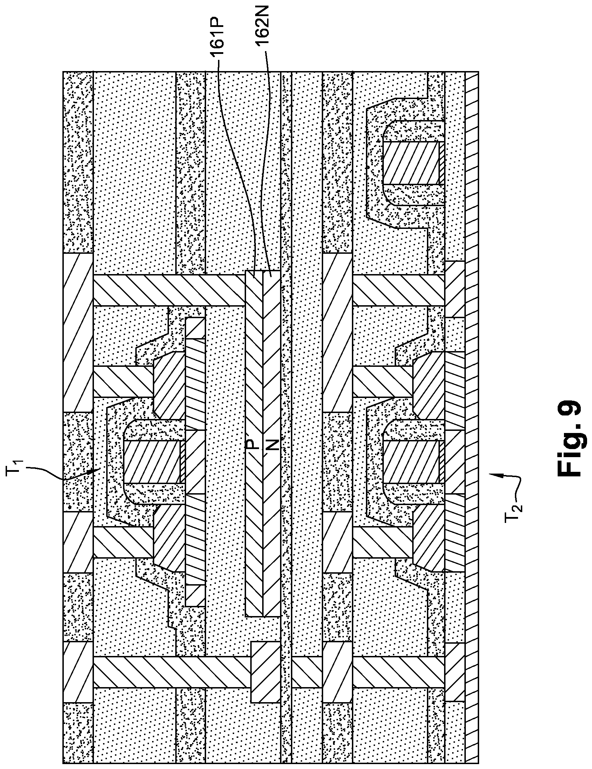

Sur la figure 9, un exemple d'un tel dispositif est illustré et comporte un transistor $T_3$ par exemple d'un circuit de traitement situé à un niveau donné $N_k$ d'une pluralité de niveaux de composants superposés, tandis que les transistors formant l'inverseur logique photosensible (seul le transistor $T_1$ de type P étant illustré sur cette figure) sont situés à un niveau $N_{k+1}$ isupérieur.

De même que dans l'exemple de réalisation précédent, le transistor $T_3$ peut être insensible à un rayonnement lumineux, de sorte que sa tension de seuil ne varie pas ou peu en fonction de la quantité de photons que reçoit le dispositif.

Ainsi, la zone de canal du transistor $T_3$ ne se situe pas en regard d'une jonction susceptible d'agir sur sa tension de seuil.

Dans l'un ou l'autre des exemples de cellules logiques photosensibles précédemment décrits, lorsque la zone photosensible est illuminée des porteurs de charges s'accumulent dans des régions situées sous la couche isolante 101 de BOX à l'interface respectivement avec les deux jonctions PN ou NP. Lorsque les jonctions sont laissées flottante et que l'on passe ensuite d'un état d'illumination de la cellule à un état d'obscurité, le temps de décharge de ces régions peut s'avérer lent.

Une création de défauts par implantation dans les jonctions peut éventuellement permettre de faciliter cette décharge.

Une autre manière pour permettre de réaliser une décharge rapide de l'interface BOX/jonction et ce sans modifier la structure des cellules, est de prévoir un circuit de commande de polarisation de cellule(s) configuré pour émettre une impulsion spécifique d'initialisation ou d'effacement. Cette impulsion est sous forme d'un échelon de tension ou d'un front dont le sens de variation dépend du type de jonction PN ou NP située sous la couche isolante de BOX.

Cette impulsion d'initialisation ou d'effacement peut être appliquée aux grilles respectives des transistors de la cellule situées en regard des jonctions et transmises par couplage électrostatique ou capacitif.

L'impulsion d'initialisation ou d'effacement peut être émise de manière périodique lors d'une phase d'initialisation ou d'effacement prévue lors de chaque cycle de fonctionnement de la cellule logique photosensible et peut précéder ou suivre chaque phase de lecture dans laquelle on vient lire l'état logique de la cellule.

Ainsi, un exemple de séquence de fonctionnement d'une matrice de cellules logiques photosensibles suivant ce principe comprend une phase d'initialisation de la matrice, puis une phase d'attente par exemple de l'ordre de plusieurs nano-secondes pendant lesquelles les cellules illuminées se chargent, puis une phase de lecture. Ensuite, une telle séquence est réitérée.

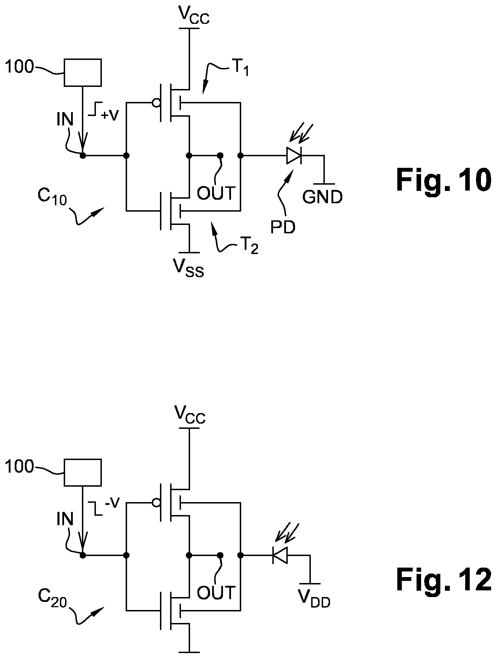

La figure 10 illustre un exemple de dispositif doté d'un tel circuit de commande 100 de polarisation adapté à une cellule logique $C_{10}$ photosensible. Cette cellule $C_{10}$ a une configuration des jonctions semblable à celle de la cellule décrite précédemment en liaison avec les figures 3A et 3B, c'est-à-dire avec des zones dopées P disposées sur les zones dopées N et intercalées ainsi entre les zones dopées N et la couche isolante de BOX. La représentation utilisée pour montrer l'effet de couplage entre face avant et face arrière du substrat est telle que les transistors sont représentés avec une deuxième grille en face arrière, les jonctions étant quant à elles symbolisées par une photodiode PD.

Dans cet exemple, où les charges accumulées en face arrière sous la couche isolante de BOX sont des trous, l'échelon de tension émis par le circuit 100 pour permettre d'accélérer la décharge à l'interface BOX/jonction est un échelon de tension positif, appliqué à la borne IN reliée aux grilles des transistors $T_1$ et $T_2$ de la cellule $C_{20}$. L'amplitude de l'échelon dépend notamment du type de transistors et de la technologie dans laquelle les transistors de la cellule sont réalisés.

Le tableau suivant récapitule différents état de polarisation des transistors $T_1$ et $T_2$ de la cellule $C_{10}$ lors de ses différentes phases de fonctionnement..

| Phase | IN | OUT | Vcc | Vss |
|---|---|---|---|---|
| Illumination | | | GND | GND |

(suite)

| Phase | IN | OUT | Vcc | Vss |
|---|---|---|---|---|
| Lectu re | $V_{IN}$ | $V_{OUT}$ | VDD | GND |
| Effacement | Front montant sur $V_{IN}$ | | | |

Sous illumination, les sources respectives des transistors $T_1$, $T_2$ peuvent être avantageusement mises par le circuit de commande 100 de polarisation à un potentiel de masse GND afin de minimiser les fuites.

Lors de la phase d'effacement, le circuit de commande 100 de polarisation applique un échelon de tension ascendant sur la grille des transistors $T_1$ et $T_2$ de la cellule $C_{10}$. Un tel échelon peut être également être appliqué sur les régions de source et de drain des transistors $T_1$, $T_2$. Un tel échelon peut être également être appliqué sur une grille des transistors $T_1$, $T_2$ disposée en face arrière et intercalée entre la jonction et la couche isolante de BOX.

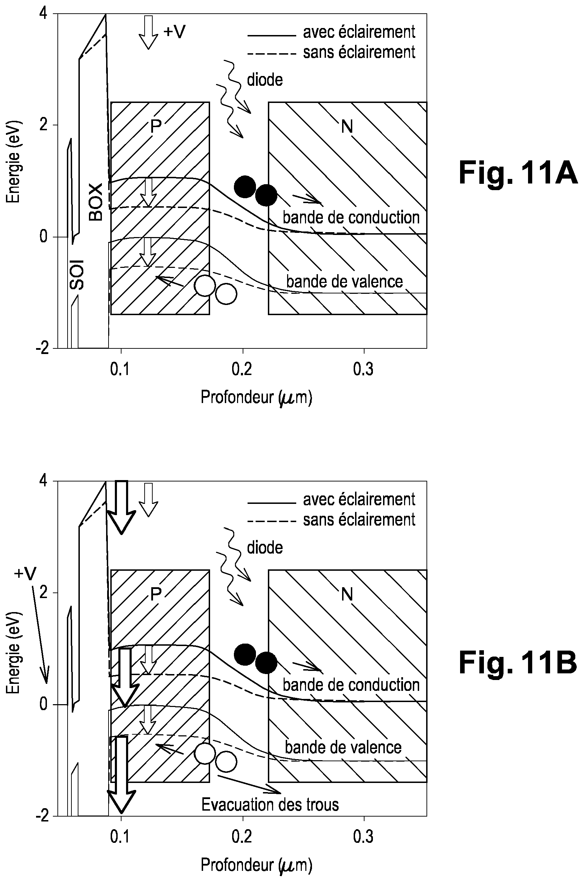

Les figures 11A-11B permettent d'illustrer l'effet d'un échelon de tension (figure 11B) sur la structure de bande en face arrière de la cellule $C_{20}$.

La figure 12 illustre une variante de réalisation adaptée à une cellule logique $C_{20}$ photosensible dont la configuration est semblable à celle décrite précédemment en liaison avec les figures 2A et 2B, c'est-à-dire dans laquelle les zones dopées N des jonctions sont disposées sur les zones dopées P et sont ainsi intercalées entre les zones dopées P et la couche isolante de BOX.

Dans cet exemple, où les charges accumulées en face arrière sous la couche isolante de BOX sont des électrons, l'échelon de tension émis par le circuit 100 pour permettre d'accélérer la décharge à l'interface BOX/jonction est un échelon de tension descendant, appliqué à la borne IN reliée aux grilles respectives du premier transistor $T_1$ et du deuxième transistor $T_2$.

Le tableau suivant récapitule différents état de polarisation des transistors $T_1$ et $T_2$ de la cellule $C_{20}$ lors de ses différentes phases de fonctionnement..

| Phase | IN | OUT | Vcc | Vss |
|---|---|---|---|---|
| Illumination | | | GND | GND |
| Lectu re | $V_{IN}$ | $V_{OUT}$ | VDD | GND |
| Effacement | Front descendant sur $V_{IN}$ | | | |

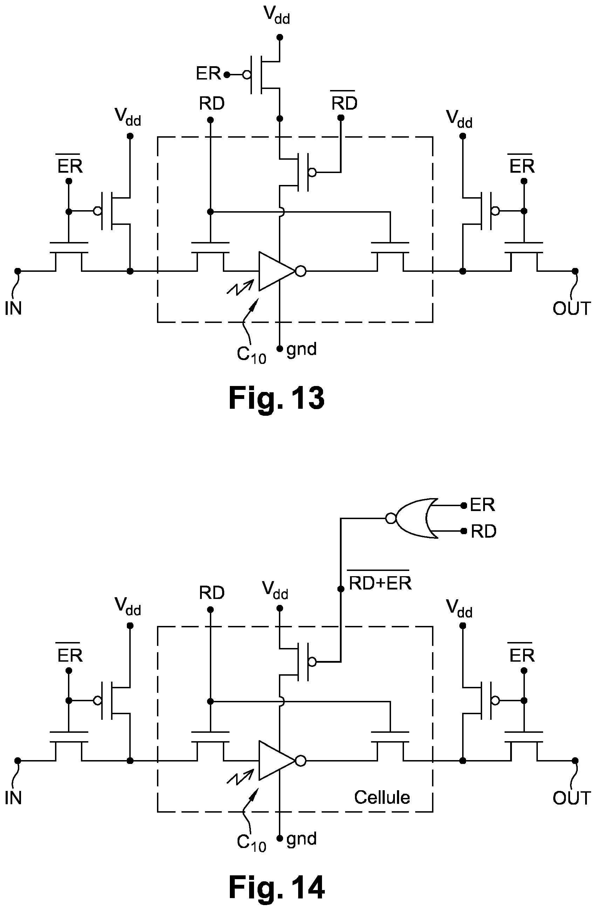

Des exemples de mise en œuvre d'un circuit de commande de polarisation à l'aide de transistors NMOS et PMOS et configuré pour modifier l'état de polarisation d'une cellule logique photosensible $C_{10}$ telle que décrite précédemment en liaison avec la figure 10 sont donnés sur les figures 13 et 14. L'état de polarisation de la cellule logique photosensible $C_{10}$ dépend de l'état logique de signaux de lecture RD et d'effacement ER.

De tels circuits de commande peuvent suivre la table de vérité suivante :

| ER | RD | Phase |
|---|---|---|
| 0 | 0 | Illumination |
| 0 | 1 | Lectu re |
| Front 0→1 | 1 | Effacement |

## Revendications

1. Dispositif comprenant au moins une cellule logique photosensible, la cellule logique photosensible comprenant :

un premier transistor ($T_1$) de type P et un deuxième transistor ($T_2$) de type N reposant sur un substrat semi-conducteur sur isolant, le substrat comprenant une couche semi-conductrice superficielle (102) comportant une zone de canal du premier transistor et une zone de canal dudit deuxième transistor, une couche isolante (101) séparant la couche semi-conductrice superficielle (102) d'une couche de support semi-conductrice (100), la couche isolante (101) reposant sur une face dite « face avant » de la couche de support semi-conductrice (100) opposée à une face dite face arrière de la couche de support semi-conductrice (100), la couche de support semi-conductrice comprenant au moins une zone photosensible (150), la zone photosensible (150) étant configurée pour convertir des photons pénétrant en face arrière de la couche de support (100), en porteurs de charges et comprenant une première jonction (160) disposée en regard de la zone de canal dudit premier transistor ($T_1$) et une deuxième jonction (170) disposée en regard de la zone de canal dudit deuxième transistor ($T_2$), la couche isolante étant configurée de manière à permettre un couplage capacitif entre la zone photosensible et la couche semi-conductrice superficielle, de sorte que le premier transistor et le deuxième transistor ont respectivement une première tension de seuil ($V_{TP}$) et une deuxième tension de seuil ($V_{TN}$) modulables en fonction d'une quantité de photons reçue par la zone photosensible, le premier transistor et le deuxième transistor étant agencés de manière à former un inverseur logique.

2. Dispositif selon la revendication 1, dans lequel la première jonction (160) et la deuxième jonction (170) comprennent :

- chacune une zone inférieure dopée N (162, 172) surmontée d'une zone supérieure dopée P (164, 174) ou,
- chacune une zone inférieure dopée P (164, 174) surmontée d'une zone supérieure dopée N (162, 172).

3. Dispositif selon la revendication 2, comprenant en outre :

- des moyens de polarisation du premier transistor et du deuxième transistor pour appliquer à une entrée (IN) reliée aux grilles (Gp, $G_N$) du premier et du deuxième transistor : un potentiel de polarisation fixe ($V_{PN}$, $V_{NP}$) prédéterminé, , le premier transistor et le deuxième transistor étant polarisés de manière à avoir des tensions grille-source respectives constantes.

4. Dispositif selon l'une des revendications 2 ou 3, dans lequel l'inverseur est configuré pour adopter en sortie un premier état logique traduisant un premier état d'éclairement de la zone photosensible par un rayonnement lumineux et pour adopter en sortie un deuxième état logique différent du premier état et traduisant un deuxième état d'éclairement de la zone photosensible différent du premier état d'éclairement.

5. Dispositif selon la revendication 1, dans lequel la première jonction (160) comprend une zone inférieure dopée N (162) surmontée d'une zone supérieure dopée P (164), la deuxième jonction comprenant une zone inférieure dopée P (174) surmontée d'une zone supérieure dopée N (172), ou dans lequel la première jonction (160) comprend une zone inférieure dopée P (164) surmontée d'une zone supérieure dopée N (162), la deuxième jonction comprenant une zone inférieure dopée N (172) surmontée d'une zone supérieure dopée P (174).

6. Dispositif selon la revendication 5, comprenant un moyen pour appliquer un potentiel variable ($V_{IN}$) en entrée (IN) de l'inverseur.

7. Dispositif selon l'une des revendications 1 à 6, comprenant en outre des moyens de polarisation configurés pour appliquer un potentiel ($V_{pol1}$, $V_{pol2}$) déterminé de polarisation à la zone inférieure de la première jonction (160) et/ou de la deuxième jonction (170), la zone supérieure de la première jonction (160) et/ou de la deuxième jonction (170) étant mise à un potentiel flottant.

8. Dispositif selon l'une de revendications 1 à 7, comprenant en outre au moins une tranchée isolante (181) entre le premier transistor ($T_1$) et le deuxième transistor ($T_2$), la tranchée isolante (181) traversant la couche de support et étant configurée de manière à isoler électriquement une zone dopée supérieure de la première jonction (160) d'une zone dopée supérieure de la deuxième jonction (170).

9. Dispositif selon l'une des revendications 1 à 8, comprenant en outre au moins une zone isolante (183, 185) autour du premier transistor et/ou du deuxième transistor, la zone isolante traversant la couche de support et étant configurée de manière à isoler électriquement ladite cellule d'une autre cellule ou d'un autre élément formé sur le substrat.

10. Dispositif selon l'une des revendications 1 à 9, comprenant en outre au moins un autre transistor ($T_3$) juxtaposé à ladite cellule logique, un plan de masse étant prévu dans la couche de support semi-conductrice en regard dudit autre transistor.

11. Dispositif selon l'une des revendications 1 à 10, comprenant en outre au moins un autre transistor ($T_3$) superposé à ladite cellule logique.

12. Dispositif selon l'une des revendications 1 à 11 dans lequel la cellule logique appartient à un circuit logique pour réaliser une fonction logique déterminée telle qu'une fonction NON ET ou NON OU.

**13.** Dispositif selon l'une des revendications 1 à 11 dans lequel ladite cellule logique photosensible appartient à une cellule de mémoire SRAM.

**14.** Circuit logique photosensible réalisant une fonction logique donnée doté un ou plusieurs dispositifs selon l'une des revendications 1 à 13, la fonction étant modifiable en fonction de l'éclairement du ou des dispositif(s).

**15.** Dispositif selon l'une des revendications 1 à 14, comprenant en outre un circuit de commande de polarisation configuré pour modifier l'état de polarisation des premiers et deuxièmes transistors et appliquer un échelon de tension au premier transistor et au deuxième transistor de sorte à permettre une décharge de régions situées à l'interface entre la couche isolante et respectivement la première et la deuxième jonction.

**Patentansprüche**

**1.** Vorrichtung mit zumindest einer lichtempfindlichen logischen Zelle, wobei die lichtempfindliche logische Zelle enthält:

einen ersten Transistor ($T_1$) des p-Typs und einen zweiten Transistor ($T_2$) des n-Typs, die auf einem Halbleiter-auf-Isolator-Substrat aufliegen, wobei das Substrat eine oberflächliche Halbleiterschicht (102) mit einem Kanalbereich des ersten Transistors und einem Kanalbereich des zweiten Transistors, und
eine Isolierschicht (101), die die oberflächliche Halbleiterschicht (102) von einer Halbleiterträgerschicht (100) trennt, aufweist, wobei die Isolierschicht (101) auf einer sogenannten "Vorderseite" der Halbleiterträgerschicht (100) aufliegt, die einer sogenannten "Rückseite" der Halbleiterträgerschicht (100) entgegengesetzt ist,
wobei die Halbleiterträgerschicht mindestens einen lichtempfindlichen Bereich (150) enthält, wobei der lichtempfindliche Bereich (150) dazu ausgelegt ist, Photonen, die an der Rückseite der Trägerschicht (100) eindringen, in Ladungsträger umzuwandeln, und einen ersten Übergang (160), der dem Kanalbereich des ersten Transistors ($T_1$) gegenüberliegend angeordnet ist,
und einen zweiten Übergang (170) aufweist, der dem Kanalbereich des zweiten Transistors ($T_2$) gegenüberliegend angeordnet ist, wobei die Isolierschicht dazu ausgelegt ist, eine kapazitive Kopplung zwischen dem lichtempfindlichen Bereich und der oberflächlichen Halbleiterschicht zu ermöglichen, so dass der erste Transistor und der zweite Transistor jeweils eine erste Schwellenspannung ($V_{TP}$) bzw. eine zweite Schwellenspannung ($V_{TN}$) aufweisen, die in Abhängigkeit von einer von dem lichtempfindlichen Bereich empfangenen Photonenmenge moduliert werden können,
wobei der erste Transistor und der zweite Transistor so angeordnet sind, dass sie einen logischen Inverter bilden.

**2.** Vorrichtung nach Anspruch 1, wobei der erste Übergang (160) und der zweite Übergang (170) enthalten:

- jeweils einen n-dotierten unteren Bereich (162, 172), der von einem p-dotierten oberen Bereich (164, 174) überragt wird, oder
- jeweils einen unteren p-dotierten Bereich (164, 174), der von einem oberen n-dotierten Bereich (162, 172) überlagert wird.

**3.** Vorrichtung nach Anspruch 2, ferner enthaltend:

- Mittel zum Vorspannen des ersten Transistors und des zweiten Transistors, um an einen Eingang (IN), der mit den Gates ($G_P$, $G_N$) des ersten und des zweiten Transistors verbunden ist, ein vorbestimmtes festes Vorspannungspotential ($V_{PN}$, $V_{NP}$) anzulegen, wobei der erste Transistor und der zweite Transistor so vorgespannt werden, dass sie jeweils konstante Gate-Source-Spannungen haben.

**4.** Vorrichtung nach einem der Ansprüche 2 oder 3, wobei der Inverter dazu ausgelegt ist, an seinem Ausgang einen ersten logischen Zustand anzunehmen, der einen ersten Beleuchtungszustand des lichtempfindlichen Bereichs durch Lichtstrahlung widergibt, und an seinem Ausgang einen zweiten logischen Zustand anzunehmen, der sich von dem ersten Zustand unterscheidet und einen zweiten Beleuchtungszustand des lichtempfindlichen Bereichs widergibt, der sich von dem ersten Beleuchtungszustand unterscheidet.

**5.** Vorrichtung nach Anspruch 1, wobei der erste Übergang (160) einen unteren n-dotierten Bereich (162) aufweist, der von einem oberen p-dotierten Bereich (164) überragt wird, wobei der zweite Übergang einen unteren p-dotierten Bereich (174) aufweist, der von einem oberen n-dotierten Bereich (172) überragt wird, oder
wobei der erste Übergang (160) einen unteren p-dotierten Bereich (164) aufweist, der von einem oberen n-dotierten Bereich (162) überragt wird, wobei der zweite Übergang einen unteren n-dotierten Bereich (172) aufweist, der von einem oberen p-dotierten Bereich (174) überragt wird.

6. Vorrichtung nach Anspruch 5, enthaltend Mittel zum Anlegen eines variablen Potentials ($V_{IN}$) an den Eingang (IN) des Inverters.

7. Vorrichtung nach einem der Ansprüche 1 bis 6, ferner enthaltend Polarisationsmittel, die dazu ausgelegt sind, ein bestimmtes Polarisationspotential ($V_{pol1}$, $V_{pol2}$) an den unteren Bereich des ersten Übergangs (160) und/oder des zweiten Übergangs (170) anlegen, wobei der obere Bereich des ersten Übergangs (160) und/oder des zweiten Übergangs (170) auf ein schwebendes Potential gesetzt ist.

8. Vorrichtung nach einem der Ansprüche 1 bis 7, ferner enthaltend zumindest einen isolierenden Graben (181) zwischen dem ersten Transistor ($T_1$) und dem zweiten Transistor ($T_2$), wobei der isolierende Graben (181) durch die Trägerschicht hindurchgeht und dazu ausgelegt ist, einen oberen dotierten Bereich des ersten Übergangs (160) von einem oberen dotierten Bereich des zweiten Übergangs (170) elektrisch zu isolieren.

9. Vorrichtung nach einem der Ansprüche 1 bis 8, ferner enthaltend zumindest einen isolierenden Bereich (183, 185) um den ersten Transistor und/oder den zweiten Transistor herum, wobei der isolierende Bereich durch die Trägerschicht hindurchgeht und dazu ausgelegt ist, die Zelle von einer anderen Zelle oder einem anderen auf dem Substrat gebildeten Element elektrisch zu isolieren.

10. Vorrichtung nach einem der Ansprüche 1 bis 9, ferner enthaltend zumindest einen weiteren Transistor ($T_3$), der neben der logischen Zelle angeordnet ist, wobei dem weiteren Transistor gegenüberliegend eine Masseebene in der Halbleiterträgerschicht vorgesehen ist.

11. Vorrichtung nach einem der Ansprüche 1 bis 10, ferner enthaltend zumindest einen weiteren Transistor ($T_3$), der der logischen Zelle überlagert ist.

12. Vorrichtung nach einem der Ansprüche 1 bis 11, wobei die logische Zelle zu einer logischen Schaltung zum Ausführen einer bestimmten logischen Funktion, wie etwa einer NAND- oder NOR-Funktion, gehört.

13. Vorrichtung nach einem der Ansprüche 1 bis 11, wobei die lichtempfindliche logische Zelle zu einer SRAM-Speicherzelle gehört.

14. Lichtempfindliche logische Schaltung, die eine gegebene logische Funktion ausführt und mit einer oder mehreren Vorrichtungen nach einem der Ansprüche 1 bis 13 versehen ist, wobei die Funktion in Abhängigkeit von der Beleuchtung der Vorrichtunge(en) veränderbar ist.

15. Vorrichtung nach einem der Ansprüche 1 bis 14, ferner enthaltend eine Vorspannungssteuerschaltung, die dazu ausgelegt ist, den Vorspannungszustand des ersten und des zweiten Transistors zu ändern und eine Spannungsstufe an den ersten Transistor und an den zweiten Transistor anzulegen, um eine Entladung von Bereichen an der Grenzfläche zwischen der Isolierschicht und dem ersten bzw. zweiten Übergang zu ermöglichen.

**Claims**

1. Device comprising at least one photosensitive logic cell, the photosensitive logic cell comprising:

a first transistor ($T_1$) of the P type and a second transistor ($T_2$) of the N type based on semiconductor substrate on insulator, the substrate comprising a semiconductor surface area (102) comprising a channel zone of the first transistor and a channel zone of said second transistor, an insulating layer (101) separating the semiconductor surface area from a semiconductor support layer (100),
the semiconductor support layer comprising at least one photosensitive zone (150) configured to convert photons into charge carriers and comprising a first junction (160) arranged opposite the channel zone of said first transistor and a second junction (170) arranged opposite the channel zone of said second transistor, with the insulating layer being configured in such a way as to allow for a capacitive coupling between the photosensitive zone and the semiconductor surface area, in such a way that the first transistor and the second transistor respectively have a first threshold voltage ($V_{TP}$) and a second threshold voltage ($V_{TN}$) that can be modulated according to a quantity of photons received by the photosensitive zone,
the first transistor and the second transistor being arranged in such a way as to form a logic inverter.

2. Device according to claim 1, wherein the first junction and the second junction each comprise:

- an N-doped lower zone (162, 172) surmounted by a P-doped upper zone (164, 174) or,
- a P-doped lower zone (164, 174) surmounted by a N-doped upper zone (162, 172),

3. Device according to claim 2, further comprising:

- biasing means of the first transistor and of the second transistor for applying at the input (IN) connected to the gates (Gp, Gn) of the first and second transistor: a fixed determined biasing potential, the first transistor and the second transistor being biased so that their respective gate to source voltages are fixed.

4. Device according to any of the claims 2 or 3, wherein the inverter is configured to adopt at the output a first logic state translating a first illumination state of the photosensitive zone by a light radiation and in order to adopt at output a second logic state different from the first state and translating a second illumination state of the photosensitive zone different from the first illumination state.

5. Device according to claim 1, wherein the first junction (160) comprises an N-doped lower zone (162) surmounted by a P-doped upper zone (164) and the second junction comprises a P-doped lower zone (174) surmounted by an N-doped upper zone (172), or
wherein the first junction (160) comprises a P-doped lower zone (164) surmounted by an N-doped upper zone (162) and the second junction comprises an N-doped lower zone (172) surmounted by a P-doped upper zone (174).

6. Device according to claim 5, comprising a circuit for applying a variable potential ($V_{IN}$) as input (IN) of the inverter.

7. Device according to any of the claims 1 to 6, further comprising a biasing means configured to apply a determined biasing potential ($V_{pol1}$, $V_{pol2}$) to the lower zone of the first junction (160) and/or of the second junction (170), with the upper zone of the first junction (160) and/or of the second junction (170) being set to a floating potential.

8. Device according to any of the claims 1 to 7, further comprising at least one isolating trench (181) between the first transistor ($T_1$) and the second transistor ($T_2$), with the isolating trench passing through the support layer and being configured in such a way as to electrically isolate an upper doped zone of the first junction (160) from an upper doped zone of the second junction (170).

9. Device according to any of the claims 1 to 8, further comprising at least one isolating zone (183, 185) around the first transistor and/or the second transistor, with the isolating zone passing through the support layer and being configured in such a way as to electrically isolate said cell from another cell or from another element formed on the substrate.

10. Device according to any of the claims 1 to 9, further comprising at least one other transistor ($T_3$) juxtaposed with said logic cell, a ground plane being provided in the semiconductor support layer opposite said other transistor.

11. Device according to any of the claims 1 to 10, further comprising at least one other transistor ($T_3$) superimposed with said logic cell.

12. Device according to any of the claims 1 to 11 wherein the logic cell belongs to a logic circuit in order to carry out a determined logic function such as a NOT AND or NOT OR function.

13. Device according to any of the claims 1 to 11, wherein said photosensitive logic cell belongs to a SRAM memory cell.

14. Photosensitive logic circuit creating a given logic function and provided with a device according to any of the claims 1 to 13, with the logic function able to be modified according to the illumination of the device or devices.

15. Device according to any of the claims 1 to 14, further comprising a biasing control circuit configured to modify the biasing state of the first and second transistors and apply a step voltage to the first transistor and to the second transistor in such a way as to allow for a discharge of regions located at the interface between the insulating layer and respectively the first and the second junction.

**Fig. 1A**

EP 2 947 689 B1

Fig. 1B

Fig. 1C

**Fig. 2A**

**Fig. 2B**

**Fig. 2C**

**Fig. 2D**

**Fig. 3A**

**Fig. 3B**

Fig. 3C

Fig. 3D

**Fig. 4A**

**Fig. 4B**

**Fig. 4C**

Fig. 4D

Fig. 4E

$T_1$

$C_4$

104

124 — $T_2$

162

174

N

P

P

N

164    160              170  172

**Fig. 5A**

$V_{DD}$

$G_P$    $D_P$

IN

OUT    $S_P$

**Fig. 5B**

$D_N$

$G_N$

$V_{IN}$    $V_{OUT}$

$S_N$

IDS
(log)    $V_{IN}$

PFET              NFET

502b

501a

501b    *    *    502a

**Fig. 5C**    501    502

-VDD    VtP  VtP* VtN* VtN    VDD    VGS

**Fig. 5D**

**Fig. 6A**

**Fig. 6B**

**Fig. 6C**

704

710

162

164

160

**Fig. 7**

T₁      T₂      T₃

N

P

N

P

P      895

100

**Fig. 8**

**Fig. 9**

**Fig. 10**

**Fig. 12**

**Fig. 11A**

**Fig. 11B**

**Fig. 13**

**Fig. 14**

**EP 2 947 689 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009003105 A1

- EP 2587539 A